# EUROPÄISCHE PATENTSCHRIFT

(11) **EP 2 453 037 B1**
(45) Veröffentlichungstag und Bekanntmachung des Hinweises auf die Patenterteilung: **05.09.2018**
(21) Anmeldenummer: 11008878.8
(22) Anmeldetag: 08.11.2011
(51) Int. Cl.: C23C 14/24

(54) **Tiegel zur Aufnahme eines Werkstoffs, der mit einem CVD- oder PVD-Verfahren verdampft werden soll**
Crucible for holding a material to be evaporated using a CVD or PVD method
Creuset pour la réception d'une matière première devant être évaporée selon un procédé CVD ou PVD

(30) Priorität: 10.11.2010 DE 102010052143
(43) Veröffentlichungstag der Anmeldung: 16.05.2012
(73) Patentinhaber: Fraunhofer-Gesellschaft zur Förderung der angewandten Forschung e.V., 80686 München (DE)
(72) Erfinder: Zimmer, Otmar, Dr., 01157 Dresden (DE); Schenk, Steffen, 01324 Dresden (DE)
(74) Vertreter: Pfenning, Meinig & Partner mbB

(56) Entgegenhaltungen:
- EP-A2- 1 505 167
- US-A1- 2005 072 361
- US-A1- 2005 208 216
- US-A1- 2006 115 243
- US-B1- 6 214 286

## Beschreibung

Die Erfindung betrifft einen Tiegel zur Aufnahme eines Werkstoffs, der mit einem CVD- oder PVD-Verfahren verdampft werden soll. Er ist insbesondere für die energieeffiziente Verdampfung von Aluminium und Aluminiumlegierungen sowie für die Elektronenstrahlverdampfung im Vakuum vorteilhaft geeignet.

Üblicherweise werden Tiegel, die eine offene Seite aufweisen und die aus einem keramischen Werkstoff, wie z.B. Aluminiumoxid oder BN hergestellt sind, eingesetzt. Es ist aber auch bekannt, Tiegel aus Graphit oder einem Metall, insbesondere Kupfer einzusetzen. Letztgenannte werden ausschließlich für das Elektronenstrahlverdampfen genutzt.

Tiegel aus elektrisch nicht leitender Keramik, z.B. aus Aluminiumoxid, werden beispielsweise für das Elektronenstrahlverdampfen von Aluminium eingesetzt. Zur Vermeidung unerwünschter elektrostatischer Aufladungen ist es erforderlich, eine an Erdpotential angeschlossene, sich bei der Nutzung verbrauchende Elektrode, die beispielsweise aus Graphit besteht, in die Schmelze des zu verdampfenden Werkstoffs einzuführen.

Die so als Monolith gefertigten Tiegel und die erforderliche Elektrode sind mit erhöhten Kosten verbunden. Die Tiegel sind außerdem für Bruch anfällig und müssen daher häufig ersetzt werden.

Tiegel aus elektrisch leitender Keramik, wie z.B. TiB_{2/}BN-Komposite werden bisher zur thermischen Verdampfung von Aluminium in Verbindung mit einer kontinuierlichen Drahtzuführung eingesetzt. Es ist dabei eine elektrische Beheizung vorgesehen.

Diese Tiegelwerkstoffe weisen bei den typischen Verdampfungstemperaturen (> 1000 °C) ein hohes Benetzungsvermögen an der Oberfläche für schmelzflüssiges Aluminium auf. Für die Aufnahme großer Mengen eines solchen Verdampfungswerkstoffs sind sie daher ungeeignet, da dieser über den Tiegelrand entweichen kann. Erstarrt die Schmelze nach Abschluss des Verdampfungsvorgangs und/oder dem Beenden einer Beheizung, bildet die Schmelze einen festen Verbund mit der Tiegelwand, was bei einer Wiedererwärmung zum Bruch des Tiegels führen kann.

Außerdem sind aus BN hergestellte Tiegel mechanisch instabil, so dass Tiegel mit großem Innenvolumen nicht,mit,ausreichender Festigkeit hergestellt werden können. Außerdem treten bereits nach kurzer Betriebszeit Auswaschungen an den Wänden auf. Da sie ebenfalls als Monolith hergestellt werden, sind die entsprechenden Kosten hoch.

Bei Tiegeln aus Graphit ist ebenfalls ein gutes Benetzungsverhalten der Oberfläche für schmelzflüssiges Aluminium nachteilig, wie dies bereits für das TiB_{2/}BN-Komposit erwähnt wurde. Sie sind daher ebenfalls für eine Elektronenstrahlverdampfung ungeeignet.

Üblicherweise werden sie durch spanende Bearbeitung aus einem massiven Graphitblock hergestellt.

Da sie lediglich einmal genutzt werden können, sind die Kosten bei ihrem Einsatz ebenfalls hoch.

Tiegel aus Metall werden in der Regel gekühlt. Durch die erforderliche Kühlung, bevorzugt Wasserkühlung, und den metallischen Werkstoff entstehen ebenfalls höhere Kosten und Aufwand. Insbesondere durch die Kühlung treten erhebliche Energieverluste von bis zu 95 % auf.

Da schmelzflüssiges Aluminium zu einem Auflösen von Metallen führt, wird die Lebensdauer dieser Tiegel verkürzt. Solche Metalltiegel sind ausschließlich für das Elektronenstrahlverdampfen geeignet.

So ist aus kein Tiegel bekannt, bei dem mindestens ein flächiges Dichtelement zwischen einer Stirnseite eines innen Hohlen und an zwei gegenüberliegenden Seiten offenen Gehäuseelements und einem Grundplattenelement angeordnet und das Gehäuseelement mittels einer.Haltevorrichtung eine Druckkraft auf das Grundplattenelement eine Druckkraft ausübt und dieses vorgespannt ist.

Die US 2006/0115243 A1 betrifft ein Widerstandsheizschiffchen und ein Herstellungsverfahren dazu.

Eine Schmelzkammer mit einer zylinderförmigen Hülse mit einem wassergekühlten Basiskörper ist in US 6 214 286 B1 beschrieben.

In US 2005/0072361 A1 ist ein mehrschichtiger thermischer Verdampfer und ein Verfahren zu dessen Nutzung offenbart.

Eine Verdampferquelle in der ein zu verdampfendes Material enthalten und ein Verschlusselement im oberen Bereich einer Zelle angeordnet ist und dabei im Verschlusselememt eine Öffnung vorhanden ist, über die der Dampf entweichen kann, ist in EP 1 505 167 A2 beschrieben.

Es ist daher Aufgabe der Erfindung, Tiegel für die Verdampfung von Werkstoffen mit einem CVD- oder PVD-Verfahren zur Verfügung zu stellen, die kostengünstig herstellbar, betreibbar und flexibel bei verschiedenen Verdampfungsverfahren eingesetzt werden können.

Erfindungsgemäß wird diese Aufgabe mit einem Tiegel, der die Merkmale des Anspruchs 1 aufweist, gelöst. Vorteilhafte Ausgestaltungen und Weiterbildungen der Erfindung können mit in untergeordneten Ansprüchen bezeichneten Merkmalen realisiert werden.

Ein erfindungsgemäßer Tiegel zur Aufnahme eines Werkstoffs, der mit einem CVD- oder PVD-Verfahren verdampft werden soll, ist aus mehreren einzelnen Teilen gebildet. Der Tiegel besteht dabei
- aus einem Grundplattenelement, das bevorzugt aus einem elektrisch leitenden Werkstoff gebildet oder damit beschichtet ist,
- einem innen hohlen, an zwei sich gegenüberliegenden Stirnseiten offenen, Gehäuseelement, das bevorzugt aus einem dielektrischen Keramikwerkstoff gebildet ist, und
- mindestens einem zwischen dem Grundplattenelement und einer Stirnseite des Gehäuseelements angeordneten flächigen Dichtelement, das bevorzugt elektrisch leitend ist. Das Gehäuseelement ist gegen das Grundplattenelement vorgespannt. Hierfür wird eine Haltevorrichtung eingesetzt, die eine Druckkraft auf das Grundplattenelement ausübt.

Die Haltevorrichtung kann dabei ein entsprechender Aufbau sein, bei dem die Druckkraft mittels Schrauben, Klemmen und/oder Exzentern aufgebracht werden kann. Vorteilhaft ist es, eine Haltevorrichtung einzusetzen, mit der eine Erhöhung der auf das Gehäuseelement gegen das/die Dichtelement(e) und das Grundplattenelement wirkenden Druckkräfte bei Erwärmung erreicht werden kann. Die wirkenden Druckkräfte erhöhen sich also bei höheren Temperaturen, was zu einer verbesserten Abdichtwirkung führt. Dafür kann ein oder es können mehrere Elemente der Haltevorrichtung aus einem geeigneten Bimetall ausgebildet sein oder es kann ein hierfür geeignetes Hebelgetriebe Bestandteil der Haltevorrichtung sein. Bei einem Hebelgetriebe kann es sich um ein Totpunktgetriebe handeln, bei dem der Totpunkt durch die thermische Ausdehnung mindestens eines Hebels oder eines anderen hierfür geeigneten Getriebeelements erreicht und überschritten werden kann.

Ein Grundplattenelement kann eine vollständig ebene planare Oberfläche aufweisen, auf der das Dichtelement aufliegt und das Gehäuseelement aufgesetzt werden kann. Es kann aber auch eine konkave Wölbung aufweisen, um die eine ebene planare Fläche ausgebildet ist, auf der Dichtelement und Gehäuseelement aufgelegt und aufgesetzt werden können.

Das Grundplattenelement kann aus Kohlenstoff oder einem elektrisch leitenden Keramikwerkstoff und das Dichtelement aus graphitischem Kohlenstoff gebildet sein. Ein Grundplattenelement kann dabei vollständig aus Graphit bestehen oder eine solche Oberflächenschicht aufweisen. Das Substrat einer so beschichteten Grundplatte kann dabei aus einem keramischen Werkstoff bestehen. Eine Oberflächenschicht eines Grundplattenelements kann auch aus diamantähnlichem Kohlenstoff gebildet sein. Als elektrisch leitende keramische Werkstoffe können SiC oder Molybdänsilizid eingesetzt werden.

Das Gehäuseelement ist bevorzugt ein Hohlzylinder. Es kann aus einem Keramikwerkstoff gebildet sein, der ausgewählt ist aus Al₂O₃, ZrO, Si₃N₄, SiC, MgO und BN. Dabei kann es auch aus mindestens zwei keramischen Werkstoffen gebildet sein. Diese können eine Mischkeramik bilden, aus der das gesamte Gehäuseelement hergestellt werden kann. Das Gehäuseelement kann aber auch mit mehreren Schichten (mehrlagig) aus unterschiedlichen keramischen Werkstoffen hergestellt werden. So kann ein Gehäuseelement beispielsweise außen mit einer Schale aus Al₂O₃ und innen mit einer Schale aus BN gebildet sein. Die innere Schale steht dann im Kontakt zum zu verdampfenden Werkstoff. Dadurch können die für die Anwendung vorteilhaften Eigenschaften der verschiedenen keramischen Werkstoffe genutzt werden. Bei Al₂O₃ ist dies beispielsweise die höhere mechanische Festigkeit und thermische Beständigkeit.

Zur Verbesserung der Temperaturwechselbeständigkeit (Thermoschock) ist es günstig den Werkstoff des Gehäuseelements mit einer besonders geeigneten Porosität zu wählen. Die Porosität sollte im Bereich 5 % bis 25 % liegen.

Das Dichtelement kann mit mindestens einer aus Graphit gebildeten Folie gebildet sein. Es oder sie sollte(n) dabei für die Erreichung einer ausreichenden Dichtwirkung entsprechend plastisch verformbar sein, so dass sich das Gehäuseelement beim Verspannen mit der Haltevorrichtung in den Graphit eindrückt.

Das/die Dichtelement(e) und/oder ein elektrisch leitendes Grundplattenelement bzw. dessen elektrisch leitender Bereich sollten elektrisch an Erdpotential angeschlossen werden können, um elektrostatische Aufladungen zu vermeiden. Dadurch kann eine unerwünschte Streuung und Reflexion hochenergetischer Elektronen, wie sie beim Elektronenstrahlverdampfen genutzt werden, vermieden und so die Energieeffizienz verbessert werden.

Am, im und/oder unterhalb des Grundplattenelement(s) kann ein Heizelement vorhanden sein, mit dem der Tiegel mit dem darin enthaltenen zu verdampfenden Werkstoff vorgewärmt oder schmelzflüssig gehalten werden kann. Das Heizelement kann als elektrische Widerstandsbeheizung, die mit mindestens einem elektrischen Leiter aus einem elektrisch leitenden Keramikwerkstoff (z.B. Molybdänsilizid) oder Wolfram gebildet ist, ausgebildet sein. Mit dem Heizelement kann ein Erstarren der Schmelze vermieden werden, was zu einer Verlängerung der Lebensdauer des Tiegels führt.

Die Energieeffizienz kann allein oder zusätzlich auch mit einer Wärmedämmung, mit der bevorzugt die Abstrahlung von Wärme vom Tiegel ausgehend erheblich reduziert werden kann, erhöht werden. Hierfür kann an der Außenwand des Gehäuseelements eine Wärmedämmung angebracht sein oder daran angebracht werden. Eine Wärmedämmung kann auch mit einem in einem Abstand zur Außenwand des Gehäuseelements angeordneten Wärmedämmelement erreicht werden, das das Gehäuseelement umschliesst.

Die Wärmedämmung kann aus porösem Graphit, aus fadenförmigem Graphit, bei dem die Fäden miteinander verwebt sind oder ein Gewirk bilden oder einem thermisch resistenten Wärme dämmenden Werkstoff, insbesondere einem Keramikschaum oder miteinander verbundenen Keramikfasern gebildet sein.

Wird durch die Nutzung und ggf. auftretenden Verschleiss ein Tiegel unbrauchbar, ist in der Regel lediglich ein Austausch des Gehäuseelements und eventuell der Wärmedämmung sowie des/der Dichtelemente(s) erforderlich. Gehäuseelemente können kostengünstig, beispielsweise durch ein thermisches Beschichtungsverfahren (z.B. Plasmaspritzen) hergestellt werden. Dabei kann der keramische Werkstoff auf die Oberfläche eines temporären Trägers, beispielsweise ein Metallrohr aufgespritzt und nach Abkühlung wegen der unterschiedlichen thermischen Ausdehnungskoeffizienten leicht ein für Gehäuseelemente geeigneter hohlzylindrischer Körper vom Rohr abgezogen werden, der in einzelne ringförmige Gehäuseelemente durch Schneiden zerteilt werden kann.

Nachfolgend soll die Erfindung beispielhaft erläutert werden.

Dabei zeigt:

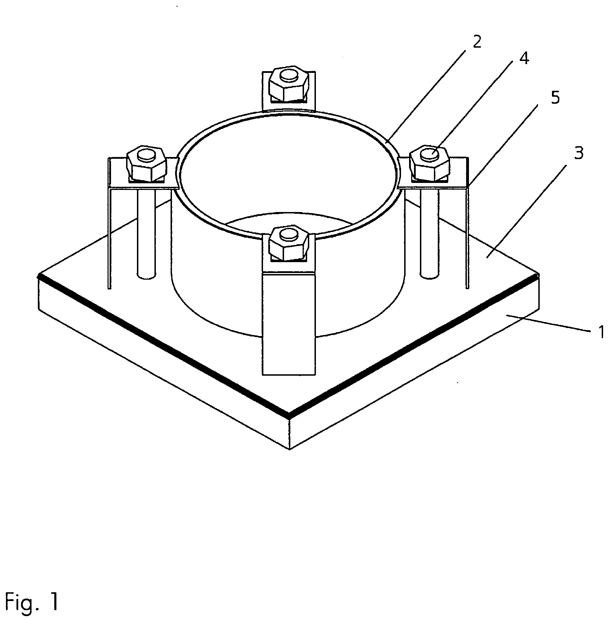

Figur 1 eine Beispiel der Erfindung in perspektivischer Darstelllung.

Der gezeigte erfindungsgemäße Tiegel weist ein Grundplattenelement 1, das vollständig aus Graphit besteht, auf. Es hat Abmessungen von 20 mm x 200 mm x 25 mm. Auf das Grundplattenelement 1 ist ein planares flächiges Dichtelement 3, das eine Folie aus Graphit mit den Abmessungen 200 mm x 200 mm x 0,8 mm ist, aufgelegt. Auf das Dichtelement 3 kann dann, das als Hohlzylinder ausgebildete Gehäuseelement 2 aufgesetzt werden. Das Gehäuseelement 2 ist aus einer Al₂O₃/ZrO-Mischkeramik gebildet. Es hat Abmessungen 122 mm Durchmesser, 70 mm Höhe und eine Wandstärke von 6 mm.

Das Halteelement mit dem das Gehäuseelement 2 und das Grundplattenelement 1 miteinander verspannt sind, ist hier mit einer Schraub-Klemmverbindung gebildet. Die jeweils vier Schrauben 4 bestehen aus Graphit und die vier Klammern 5, die an der oberen Stirnseite des Gehäuseelements 2 angreifen sind als Carbon-Faser verstärkter Komposit (CFC) gebildet.

Der Tiegel nach diesem Beispiel kann bevorzugt für eine Elektronenstrahlverdampfung von Aluminium oder Aluminiumlegierungen eingesetzt werden.

Bei Bedarf können Gehäuseelement 2 und/oder Dichtelement 3 durch lösen und nachfolgend wieder herstellen der Schraub-Klemmverbindung mit den Elementen der Haltevorrichtung schnell und einfach ausgetauscht werden.

## Patentansprüche

1. Tiegel zur Aufnahme eines Werkstoffs, der mit einem CVD- oder PVD-Verfahren verdampft werden soll,
**dadurch gekennzeichnet, dass** der Tiegel aus einem Grundplattenelement (1), einem innen hohlen an zwei sich gegenüberliegenden Stirnseiten offenen Gehäuseelement (2) und mindestens einem zwischen dem Grundplattenelement (1) und einer Stirnseite des Gehäuseelements (2) angeordneten flächigen Dichtelement (3) gebildet ist und das Gehäuseelement (2) gegen das Grundplattenelement (1), mittels einer Haltevorrichtung (4, 5) eine Druckkraft auf das Grundplattenelement (1) ausübend, vorgespannt ist.

2. Tiegel nach Anspruch 1, **dadurch gekennzeichnet, dass** das Grundplattenelement (1) aus einem elektrisch leitenden Werkstoff gebildet oder damit beschichtet ist und/oder das/die Dichtelement(e) (3) elektrisch leitend ist/sind.

3. Tiegel nach Anspruch 1 oder 2, **dadurch gekennzeichnet, dass** das Gehäuseelement (2) zumindest teilweise aus einem dielektrischen Keramikwerkstoff gebildet ist.

4. Tiegel nach einem der vorhergehenden Ansprüche, **dadurch gekennzeichnet, dass** das Grundplattenelement (1) aus Kohlenstoff oder einem elektrisch leitenden Keramikwerkstoff und das/die Dichtelement(e) (3) aus graphitischem Kohlenstoff gebildet ist/sind.

5. Tiegel nach einem der vorhergehenden Ansprüche, **dadurch gekennzeichnet, dass** das Gehäuseelement (2) aus einem Keramikwerkstoff gebildet ist, der ausgewählt ist aus Al₂O₃, ZrO, Si₃N₄, SiC, MgO und BN.

6. Tiegel nach einem der vorhergehenden Ansprüche, **dadurch gekennzeichnet, dass** das Gehäuseelement (2) aus mindestens zwei unterschiedlichen keramischen Werkstoffen, als Mischkeramik und/oder mehrschichtig gebildet ist.

7. Tiegel nach einem der vorhergehenden Ansprüche, **dadurch gekennzeichnet, dass** der das Gehäuseelement (2) bildende Keramikwerkstoff eine Porosität im Bereich 5% bis 25 aufweist.

8. Tiegel nach einem der vorhergehenden Ansprüche, **dadurch gekennzeichnet, dass** am, im und/oder unterhalb des Grundplattenelements (1) ein Heizelement vorhanden ist.

9. Tiegel nach Anspruch 4, **dadurch gekennzeichnet, dass** das Heizelement als elektrische Widerstandsbeheizung, die mit mindestens einem elektrischen Leiter aus einem elektrisch leitendem Keramikwerkstoff oder Wolfram gebildet ist, ausgebildet ist.

10. Tiegel nach einem der vorhergehenden Ansprüche, **dadurch gekennzeichnet, dass** an der Außenwand des Gehäuseelements (2) eine Wärmedämmung angebracht, daran anbringbar ist, oder in einem Abstand zur Außenwand das Gehäuseelement (2) mit einem Wärmedämmelement umschlossen ist.

11. Tiegel nach Anspruch 6, **dadurch gekennzeichnet, dass** die Wärmedämmung aus porösem Graphit, aus fadenförmigem Graphit oder einem thermisch resistenten Wärme dämmenden Werkstoff, insbesondere einem Keramikschaum oder miteinander verbundenen Keramikfasern gebildet ist.

12. Tiegel nach einem der vorhergehenden Ansprüche, **dadurch gekennzeichnet, dass** das/die Dichtelement(e) (3) mit mindestens einer aus Graphit gebildeten Folie gebildet ist.

13. Tiegel nach einem der vorhergehenden Ansprüche, **dadurch gekennzeichnet, dass** die Haltevorrichtung (4, 5) so ausgebildet ist, dass bei Erwärmung eine sich erhöhende Druckkraft auf das Gehäuseelement (2) gegen das/die Dichtelement(e) (3) und das Grundplattenelement (1) wirkt.

## Claims

1. A crucible for receiving a material that is to be evaporated using a CVD or PVD process,
**characterized in that** the crucible is formed from a base plate element (1), from an inwardly hollow housing element (2) open at two oppositely disposed end sides, and from at least one two-dimensional sealing element (3) arranged between the base plate element (1) and an end side of the housing element (2); and **in that** the housing element (2) is preloaded against the base plate element (1) by means of a holding apparatus (4, 5) exerting a compressive force on the base plate element (1).

2. A crucible in accordance with claim 1, **characterized in that** the base plate element (1) is formed from an electrically conductive material or is coated therewith; and/or **in that** the sealing element(s) (3) is/are electrically conductive.

3. A crucible in accordance with claim 1 or claim 2, **characterized in that** the housing element (2) is formed at least partly from a dielectric ceramic material.

4. A crucible in accordance with one of the preceding clams, **characterized in that** the base plate element (1) is formed from carbon or from an electrically conductive ceramic material; and/or **in that** the sealing element(s) (3) is/are formed from graphitic carbon.

5. A crucible in accordance with one of the preceding clams, **characterized in that** the housing element (2) is formed from a ceramic material that is selected from Al₂O₃, ZrO, Si₃N₄, SiC, MgO and BN.

6. A crucible in accordance with one of the preceding clams, **characterized in that** the housing element (2) is formed from at least two different ceramic materials, as a mixed ceramic material and/or in mulitlayers.

7. A crucible in accordance with one of the preceding clams, **characterized in that** the ceramic material forming the housing element (2) has a porosity in the range from 5% to 25%.

8. A crucible in accordance with one of the preceding clams, **characterized in that** a heating element is present at, in and/or below the base plate element (1).

9. A crucible in accordance with claim 4, **characterized in that** the heating element is configured as an electric resistance heater that is formed with at least one electrical conductor composed of an electrically conductive ceramic material or tungsten.

10. A crucible in accordance with one of the preceding clams, **characterized in that** a thermal insulation is attached to the outer wall of the housing element (2), is attachable thereto, or the housing element (2) is surrounded by a thermally insulating element at a spacing from the outer wall.

11. A crucible in accordance with claim 6, **characterized in that** the thermal insulation is formed from porous graphite, from thread-shaped graphite, or from a thermally resistant thermally insulating material, in particular from a ceramic foam or from ceramic fibers connected to one another.

12. A crucible in accordance with one of the preceding clams, **characterized in that** the sealing element(s) (3) is formed with at least one film formed from graphite.

13. A crucible in accordance with one of the preceding clams, **characterized in that** the holding apparatus (4, 5) is configured such that on heating an increasing compressive force acts on the housing element (2) against the sealing element(s) (3) and the base plate element (1).

## Revendications

1. Creuset pour le logement d'un matériau, qui doit être évaporé par un procédé CVD ou PVD,
**caractérisé en ce que** le creuset est constitué d'un élément à plaque de base (1), d'un élément de boîtier (2) ouvert creux à l'intérieur sur deux faces frontales opposées et d'au moins un élément d'étanchéité plat (3) disposé entre l'élément de plaque de base (1) et une face frontale de l'élément de boîtier (2) et l'élément de boîtier (2) étant précontraint contre l'élément de plaque de base (1), en exerçant au moyen d'un dispositif de maintien (4, 5), une force de pression sur l'élément de plaque de base (1).

2. Creuset selon la revendication 1, **caractérisé en ce que** l'élément de plaque de base (1) est constitué d'un matériau électro-conducteur ou est revêtu de celui-ci et/ou l'élément ou les éléments d'étanchéité (3) est/sont électro-conducteurs.

3. Creuset selon la revendication 1 ou 2, **caractérisé en ce que** l'élément de boîtier (2) est constitué au moins partiellement d'un matériau de type céramique diélectrique.

4. Creuset selon l'une des revendications précédentes, **caractérisé en ce que** l'élément de plaque de base (1) est constitué de carbone ou d'un matériau de type céramique électro-conducteur et l'élément ou les éléments d'étanchéité (3) est/sont constitué(s) de carbone graphitique.

5. Creuset selon l'une des revendications précédentes, **caractérisé en ce que** l'élément de boîtier (2) est constitué d'un matériau de type céramique, qui est sélectionné parmi Al₂O₃, ZrO, Si₃N₄, SiC, MgO et BN.

6. Creuset selon l'une des revendications précédentes, **caractérisé en ce que** l'élément de boîtier (2) est constitué d'au moins deux matériaux céramiques différents, sous la forme d'une céramique mixte et/ou en plusieurs couches.

7. Creuset selon l'une des revendications précédentes, **caractérisé en ce que** le matériau de type céramique constituant l'élément de boîtier (2) présente une porosité de l'ordre de 5 % à 25 %.

8. Creuset selon l'une des revendications précédentes, **caractérisé en ce que** sur et/ou en dessous de l'élément de plaque de base (1) se trouve un élément chauffant.

9. Creuset selon la revendication 4, **caractérisé en ce que** l'élément chauffant est conçu comme une résistance électrique, qui est constituée d'au moins un conducteur électrique en matériau de type céramique électro-conducteur ou en tungstène.

10. Creuset selon l'une des revendications précédentes, **caractérisé en ce que**, sur la paroi extérieure de l'élément de boîtier (2), une isolation thermique est montée, peut être montée ou l'élément de boîtier (2) est entouré à une certaine distance de la paroi extérieure avec un élément d'isolation thermique.

11. Creuset selon la revendication 6, **caractérisé en ce que** l'isolation thermique est constituée de graphite poreux, de graphite en forme de fils ou d'un matériau thermo-isolant avec une résistance thermique, plus particulièrement d'une mousse céramique ou de fibres céramiques reliées entre elles.

12. Creuset selon l'une des revendications précédentes, **caractérisé en ce que** l'élément ou les éléments d'étanchéité (3) est/sont constitué(s) d'au moins un film constitué de graphite.

13. Creuset selon l'une des revendications précédentes, **caractérisé en ce que** le dispositif de maintien (4, 5) est conçu de façon à ce que, lors du chauffage, une force de pression croissante agisse sur l'élément de boîtier (2) contre l'élément ou les éléments d'étanchéité (3) et l'élément de plaque de base (1).
